# EUROPEAN PATENT SPECIFICATION

(11) **EP 0 328 077 B1**
(45) Date of publication and mention of the grant of the patent: **08.06.1994**
(21) Application number: 89102165.1
(22) Date of filing: 08.02.1989
(51) Int. Cl.: H01R 13/648, H01R 13/453, H05K 5/02

(54) **Arrangement for protecting electronic devices against static electricity**
Anordnung zum Schutz elektronischer Einrichtungen gegen statische Elektrizität
Arrangement pour la protection des dispositifs électroniques contre de l'électricité statique

(30) Priority: 12.02.1988 JP 17295/88 U
(43) Date of publication of application: 16.08.1989
(73) Proprietor: SEIKO EPSON CORPORATION, Shinjuku-ku Tokyo-to (JP)
(72) Inventor: Sugai, Hiroshi, Suwa-shi Nagano-ken (JP)
(74) Representative: Hoffmann, Eckart, Dipl.-Ing.

(56) References cited:
- EP-A- 0 248 722
- US-A- 4 695 925

## Description

The present invention relates to an arrangement for removing electric charges which may be present or generated when an electronic apparatus is connected to a connector.

The document JP-A-62-77996 describes an integrated circuit card provided with a slidable shutter to protect terminals of the integrated circuit card and to expose them only when the terminals are to be connected to the terminals of a connector. Pins are provided for opening/closing the shutter. This document does, however, not describe any construction for removing electric charges which may be generated at the time when the terminals of the integrated circuit card are connected to the terminals of the connector.

When an electronic apparatus is connected to a connector, there is the danger that electronic charges that may be present or produced in the electronic apparatus during the connection process may flow into the terminals of the connector. The charges can cause misoperation of an electronic device of which the connector is a part or can damage an integrated circuit of the apparatus to be connected to the connector.

It is an object of the present invention to provide an arrangement by which such electric charges are removed before the terminals of the electronic apparatus come into contact with the terminals of the connector.

This object is achieved with an arrangement as claimed.

According to the claimed solution, a contacting member of the electronic apparatus is electrically connected to a contacting member of the connector before the terminals of the electronic apparatus come into contact with the terminals of the connector. The contacting member of the connector is electrically connected to the casing of the electronic device of which the connector is a part. Due to this construction, any charges generated in the electronic apparatus, for instance a memory card, are discharged to the ground of the electronic device, so that the electronic circuitry connected to the terminals can be protected from being affected by such charge.

An embodiment of the present invention will be explained hereinbelow with reference to the drawings, wherein
- Fig. 1: is a partial sectional view of one embodiment of a connector according to the invention,
- Fig. 2: is a side view of the connector of Fig. 1,
- Fig. 3: is a bottom plan view of a memory card as an example of an electronic apparatus,
- Fig. 4: is a sectional view along line A-A' in Fig. 3,
- Fig. 5: shows the memory card partly inserted into the connector of Fig. 1, and
- Fig. 6: shows the memory card completely inserted into the connector.

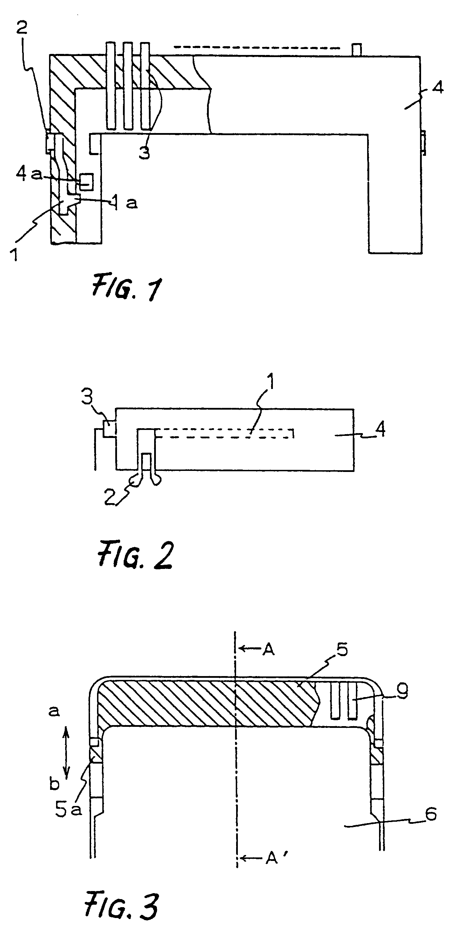

Fig. 1 shows a plan view, partially in section, of a connector according to one embodiment of the present invention. Fig. 2 is a side view from the left side of the connector. Fig. 3 is a bottom plan view, partially in section, of a memory card which is used as one example of an electronic apparatus to be connected to the connector of Figs. 1 and 2. It should be understood that the invention is of course not only applicable for memory cards but for a variety of electronic apparatus.

The connector shown in Figs. 1 and 2 has a U-shaped housing 4 with a front part and two side parts. In the front part of the housing 4 terminals 3 are provided which will be connected to terminals 9 of the memory card when the latter is introduced into the connector as will be described later. Terminals 3 extend into the inside of the housing 4. The connector will normally be part of an electric device and have its terminals 3 connected to the circuitry of this device.

On both side parts of the housing 4 contacting members 1 are provided. Each contacting member comprises a pin 2 for securing the contacting member to the housing 4. Integrally formed with the pin is a pawl provided with a projection 1a which projects into the interior of the housing 4. The contacting members 1 are made of electrically conductive metal and are resiliently urged towards the inside of the housing 4. Via the pins 2 or by other means the contact members 1 are electrically connected to a case of the device and, thus, normally to ground. Integrally formed with the housing 4 are projections 4a of which only the one on the left side is shown in Fig. 1. The contacting members 1 of the connector serve to discharge any electric charge from the memory card as it is being inserted into the connector and before its terminals 9 come into contact the terminals 3 of the connector as will be explained in detail later.

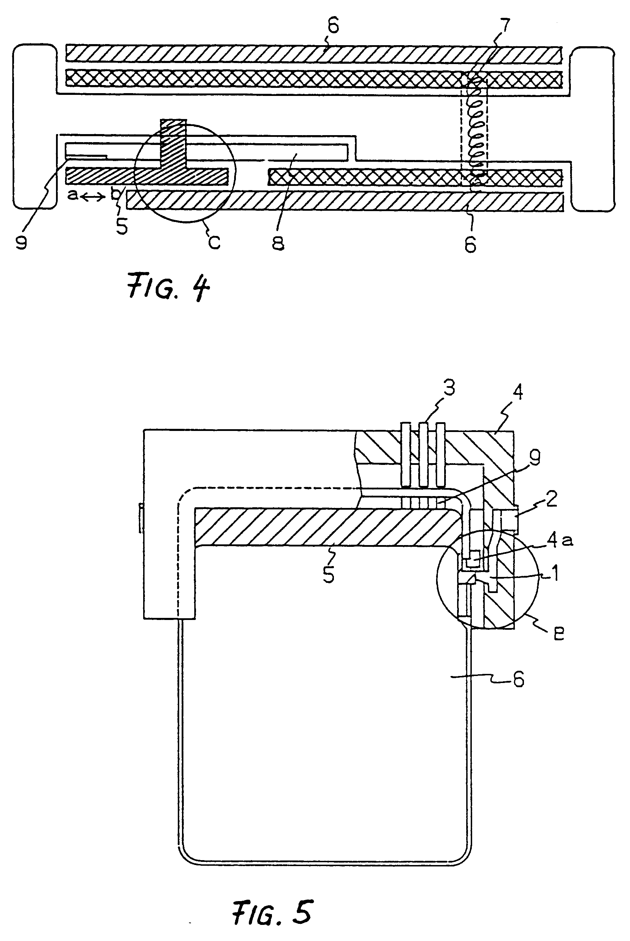

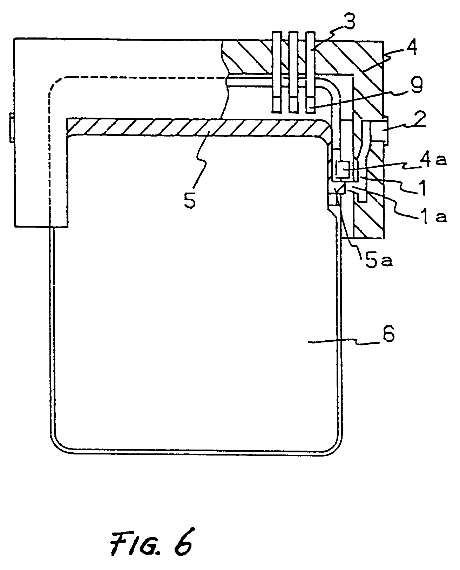

As mentioned before, Fig. 3 is a bottom plan view of the memory card, a diagrammatic sectional view of which along line A-A' being shown in Fig. 4. As to be seen from Fig. 4, the memory card includes a circuit substrate 8 on which the terminals 9 and integrated circuits (not shown) are provided. The circuit substrate 8 is sandwiched with metal panels 6 for protecting the integrated circuits on the circuit substrate 8 against external forces, static electricity, noise and so on. Insulating layers are provided on the confronting inner sides of the metal panels 6. Both metal panels 6 are electrically connected with each other as by a coil spring 7. A shutter 5 is provided to protect terminals 9 of the memory card against dust, external forces and static electricity as long as the memory card is not inserted into the connector. The shutter 5 is slidably guided in the directions of arrows a and b between a protecting position shown in Fig. 4 and a retracted position shown in Fig. 6 where the terminals 9 are exposed. As to be seen in portion C of Fig. 4, the shutter 5 which is made of an electrically conductive metal is slidable on the lower one of the metal panels 6 and, thus, is electrically connected to the metal panels. In its protecting position, the shutter 5 also contacts terminals 9 of the circuit substrate 8 so that in this position of the shutter 5, the circuits on the circuit substrate 8 and the metal plates 6 of the memory card are forced to have the same electric potential. The shutter 5 is biased by a spring (not shown) into its protecting position of Fig. 4.

As shown in Fig. 3, the shutter 5 has on each side a projection 5a to be contacted by projections 4a and projections 1a of the connector when the memory card is inserted into the connector. The projections 5a thus serve as contacting members of the memory card.

The operation of the arrangement described before will now be explained with reference especially to Figs. 5 and 6. Fig. 5 shows the memory card partly, not fully inserted into the connector. Fig. 6 is similar to Fig. 5 showing, however, the condition when the memory card is completely inserted into the connector and has its terminals 9 connected with the terminals 3 of the connector. When the memory card is inserted into the connector, before any of its terminals 9 contacts any of the terminals 3 of the connector, the projections 1a of the connecting members 1 of the connector will come into contact with the projections 5a of the shutter 5 of the memory card. At this moment, the shutter 5, the metal plates 6 and preferably the terminals 9 of the memory card are electrically connected via the connecting members 1 of the connector to ground so that any charges that may exist on the memory card are discharged to ground. When the memory card is further inserted into the connector, the projections 5a of the shutter 5 will abut against the projections 4a of the connector, preventing the shutter 5 from being moved further towards the front part of the connector. A further movement of the memory card thus results in a relative movement between the shutter 5 and the rest of the memory card, transferring the shutter 5 into its retracted position. While the shutter is moved relatively to the rest of the memory card, it is held fixed with respect to the connector due to the engagement between the projections 4a and the projections 5a. Also, the projections 1a of the connecting members 1 are maintained in a resilient contact with the projections 5a of the shutter until the memory card is removed from the connector. Due to this contact it is ensured that all parts of the memory card will be on ground potential when the memory card reaches its final position where the terminals 3 and the terminals 9 are in contact with each other. Since, as mentioned before and shown in Fig. 6, even when the memory card is completely inserted into the connector and the respective terminals are connected to each other, the shutter 5 of the memory card is electrically connected to the ground of the apparatus via the connecting members 1 and its pins 2, the memory card will be unaffected by static electricity.

When the memory card is removed from the connector, the shutter 5 while still being electrically connected to the contacting members 1 will be closed again and the contact between the projections 5a of the shutter 5 and the projections 1a of the connecting members 1 will be broken only after the shutter has reached its protecting position and the terminals 9 of the memory card have been disconnected from the terminals 3 of the connector.

## Claims

1. An arrangement for removing electric charges which may be present or generated when terminals (9) of an electronic apparatus are connected to terminals (3) of a connector of an electric device, wherein said electronic apparatus comprises a circuit board (8) carrying said terminals (9) and an electronic circuitry, metal panels (6) at least partly sandwiching said circuit board (8), and a shutter (5) movable between a first position where it covers said terminals (9), and a second position exposing them, said arrangement comprising first electrically conductive contacting members (5a) being part of or connected to the shutter (5) and second electrically conductive contacting members (1) on the connector, said contacting members being brought into contact with each other before said terminals of the electronic apparatus come into contact with the terminals of the connector, wherein said metal panels (6) are electrically connected to each other and to the shutter (5), characterised in that said shutter (5) in its first position electrically contacts the terminals (9) of the electronic apparatus.

## Patentansprüche

1. Anordnung zur Entfernung elektrischer Ladungen, die vorhanden sein oder erzeugt werden können, wenn Anschlüsse (9) eines elektronischen Bauteils mit Anschlüssen (3) eines Steckverbinders einer elektrischen Einrichtung verbunden werden, wobei das elektrische Bauteil eine Schaltungsplatine (8), welche die Anschlüsse (9) und eine elektronische Schaltungsanordnung trägt, Metallplatten (6), die zumindest teilweise die Schaltungsplatine (8) von beiden Seiten zwischen sich aufnehmen, und einen Verschluß (5), der zwischen einer ersten Position, in der er die Anschlüsse (9) bedeckt, und einer Zweiten Position, in der er sie freilegt, beweglich ist, umfaßt, und die Anordnung erste elektrisch leitende Kontaktelemente (5a), die Teil von oder in Verbindung mit dem Verschluß (5) sind, und zweite elektrisch leitende Kontaktelemente (1) an dem Steckverbinder umfaßt, wobei die Kontaktelemente gegenseitig in Kontakt gebracht werden, bevor die Anschlüsse des elektronischen Bauteils mit den Anschlüssen des Steckverbinders in Kontakt kommen, und wobei die Metallplatten (6) elektrisch miteinander und mit dem Verschluß (5) verbunden sind, dadurch gekennzeichnet, daß der Verschluß (5) in seiner ersten Position die Anschlüsse (9) des elektronischen Bauteils elektrisch leitend berührt.

## Revendications

1. Un dispositif pour éliminer des charges statiques qui peuvent être présentes ou générées lorsque des bornes (9) d'un appareil électronique sont connectées à des bornes (3) d'un connecteur d'un dispositif électrique, dans lequel l'appareil électronique comprend une carte de circuit (8) portant les bornes précitées (9) et un circuit électronique, des plaques métalliques (6) entre lesquelles la carte de circuit (8) est au moins partiellement intercalée, et un obturateur (5) pouvant être déplacé entre une première position dans laquelle il recouvre les bornes (9), et une seconde position dans laquelle il les découvre, ce dispositif comprenant des premiers éléments de contact conducteurs de l'électricité (5a) qui font partie de l'obturateur (5) ou qui sont connectés à celui-ci, et des seconds éléments de contact conducteurs de l'électricité (1) sur le connecteur, ces éléments de contact étant amenés en contact mutuel lorsque les bornes de l'appareil électronique viennent en contact avec les bornes du connecteur, et dans lequel les plaques métalliques (6) sont connectées électriquement l'une à l'autre et à l'obturateur (5), caractérisé en ce que dans sa première position, l'obturateur (5) est en contact électrique avec les bornes (9) de l'appareil électronique.
